# EUROPÄISCHE PATENTSCHRIFT

(11) **EP 2 446 449 B1**
(45) Veröffentlichungstag und Bekanntmachung des Hinweises auf die Patenterteilung: **13.06.2018**
(21) Anmeldenummer: 11757765.0
(22) Anmeldetag: 24.08.2011
(51) Int. Cl.: G01R 1/20, H01C 7/06, H01C 7/00

(54) **STROMMESSWIDERSTAND**
CURRENT-SENSING RESISTOR
RÉSISTANCE DE MESURE DE COURANT

(30) Priorität: 26.08.2010 DE 102010035485
(43) Veröffentlichungstag der Anmeldung: 02.05.2012
(73) Patentinhaber: Isabellenhütte Heusler GmbH & Co. KG, 35683 Dillenburg (DE)
(72) Erfinder: HETZLER, Ullrich, 35688 Dillenburg-Oberscheld (DE)
(74) Vertreter: Beier, Ralph
(86) Internationale Anmeldenummer: PCT/EP2011/004245
(87) Internationale Veröffentlichungsnummer: WO 2012/019784

(56) Entgegenhaltungen:
- DE-A1- 2 939 594

## Beschreibung

Die Erfindung betrifft einen Strommesswiderstand zur Messung eines elektrischen Stroms, insbesondere zur Messung eines Batteriestroms in einem Kraftfahrzeugbordnetz.

Aus EP 0 605 800 A1 ist ein derartiger Strommesswiderstand bekannt, der aus zwei plattenförmigen Anschlussteilen aus Kupfer und einem niederohmigen, ebenfalls plattenförmigen Widerstandselement aus einer Widerstandslegierung (z.B. Cu84Ni4Mn12) besteht, wobei das Widerstandselement zwischen die Anschlussteile eingesetzt und mit den Anschlussteilen verschweißt ist. Derartige Strommesswiderstände dienen zur Strommessung gemäß der bekannten Vierleitertechnik, wobei der zu messende Strom über die plattenförmigen Anschlussteile durch das Widerstandselement geleitet wird. Der Spannungsabfall über dem Widerstandselement ist dann entsprechend dem Ohmschen Gesetz ein Maß für den zu messenden elektrischen Strom. Der bekannte Strommesswiderstand weist deshalb zwei Spannungskontakte an den beiden plattenförmigen Anschlussteilen auf, wobei die Spannungskontakte nahe dem Widerstandselement angeordnet sind und es ermöglichen, den Spannungsabfall über dem Widerstandselement zu messen. Derartige Strommesswiderstände weisen nur eine relativ geringe Temperaturabhängigkeit der Messung auf, da üblicherweise ein Widerstandsmaterial (z.B. Cu84Ni4Mn12) mit einem sehr geringen Temperaturkoeffizienten verwendet wird. Die Anforderungen an die Temperaturkonstanz derartiger Strommesswiderstände nehmen jedoch noch zu.

Aus US 5 999 085 ist ein niederohmiger Strommesswiderstand bekannt, der in den Anschlussteilen jeweils einen Einschnitt aufweist, der die Anschlussteile jeweils in einen Spannungskontakt und einen Stromkontakt aufteilt. Über die beiden Stromkontakte wird der zu messende Strom in den Strommesswiderstand eingeleitet bzw. abgeleitet. Die beiden Spannungskontakte dienen dagegen entsprechend der bekannten Vierleitertechnik zur Messung der über dem Strommesswiderstand abfallenden elektrischen Spannung. Der Einschnitt in den Anschlussteilen verläuft hierbei parallel zur Stromflussrichtung zwischen den beiden Anschlussteilen und hat deshalb keinen besonders vorteilhaften Effekt auf die Temperaturstabilität der Strommessung. Insbesondere beeinflussen die Einschnitte hierbei kaum den Stromverlauf in den Anschlussteilen, da die Einschnitte parallel zur Hauptstromrichtung ausgerichtet sind.

Ferner ist zum Stand der Technik hinzuweisen auf DE 29 39 594 A1.

Der Erfindung liegt deshalb die Aufgabe zugrunde, die Temperaturkonstanz bei dem vorstehend beschriebenen herkömmlichen Strommesswiderstand zu verbessern.

Diese Aufgabe wird durch einen erfindungsgemäßen Strommesswiderstand gemäß dem Hauptanspruch gelöst.

Die Erfindung beruht auf der technisch-physikalischen Erkenntnis, dass das Leitermaterial (z.B. Kupfer) der plattenförmigen Anschlussteile einen wesentlich größeren Temperaturkoeffizienten aufweist als das Widerstandsmaterial (z.B. Cu84Ni4Mn12) des plattenförmigen Widerstandselements. Bei der Messung der über dem Widerstandselement zwischen den beiden Spannungskontakten abfallenden elektrischen Spannung wird die Messung jedoch auch durch das Material der Anschlussteile beeinflusst. Die Temperaturabhängigkeit der Spannungsmessung wird also nicht nur durch den Temperaturkoeffizienten des Widerstandsmaterials bestimmt, sondern auch durch den Temperaturkoeffizienten des Leitermaterials beeinflusst. Hierbei ist zu berücksichtigen, dass beispielsweise der Temperaturkoeffizient von Kupfer mit α =3,9·10⁻³ K⁻¹ um den Faktor 195 größer ist als der Temperaturkoeffizient von Cu84Ni4Mn12 (Manganin®) mit α = 0,02·10⁻³ K⁻¹. Aufgrund des wesentlich größeren Temperaturkoeffizienten von Kupfer beeinflussen die plattenförmigen Anschlussteile die Temperaturabhängigkeit der gesamten Messung also auch dann, wenn nur ein kleiner Teil der Spannung zwischen den Spannungskontakten über den Anschlussteilen abfällt.

Die Erfindung umfasst deshalb die allgemeine technische Lehre, in den beiden plattenförmigen Anschlussteilen jeweils einen Einschnitt gemäß Anspruch 1 vorzusehen, um die Temperaturabhängigkeit der Messung zu verringern.

Hierbei verläuft der Einschnitt hierbei mindestens teilweise quer (z.B. rechtwinklig) zur Stromflussrichtung zwischen den beiden Anschlussteilen. Der Einschnitt ist also mindestens teilweise quer (z.B. rechtwinklig) zur Verbindungslinie zwischen den beiden Anschlussteilen ausgerichtet. Anders ausgedrückt verläuft der Einschnitt vorzugsweise mindestens auf einem Teil seiner Länge parallel zur Verbindungslinie zwischen dem Widerstandselement und den angrenzenden Anschlussteilen. Dadurch unterscheidet sich der erfindungsgemäße Strommesswiderstand von dem eingangs beschriebenen bekannten Strommesswiderstand gemäß US 5 999 085, bei dem der Einschnitt parallel zur Stromflussrichtung ausgerichtet ist.

In einem bevorzugten Ausführungsbeispiel der Erfindung entspricht der erfindungsgemäße Strommesswiderstand weitgehend dem Strommesswiderstand, der in EP 0 605 800 A1 beschrieben ist. An dieser Stelle ist lediglich zu erwähnen, dass der erfindungsgemäße Strommesswiderstand zwei plattenförmige Anschlussteile aufweist, die aus einem elektrisch leitfähigen Leitermaterial (z.B. Kupfer) bestehen und zur Einleitung bzw. Ableitung des zu messenden elektrischen Stroms dienen. Darüber hinaus weist der erfindungsgemäße Strommesswiderstand ein plattenförmiges Widerstandselement auf, das im Strompfad zwischen die beiden Anschlussteile geschaltet ist und von dem zu messenden elektrischen Strom durchflossen wird, wobei das Widerstandselement aus einem Widerstandsmaterial (z.B. Cu84Ni4Mn12) besteht, das absolut betrachtet niederohmig ist, aber einen größeren spezifischen Widerstand aufweist als das Leitermaterial.

Zur Messung der über dem Widerstandselement abfallenden elektrischen Spannung als Maß für den zu messenden elektrischen Strom entsprechend dem Ohmschen Gesetz weist der erfindungsgemäße Strommesswiderstand vorzugsweise zwei Spannungskontakte auf, die elektrisch und mechanisch mit den beiden plattenförmigen Anschlussteilen verbunden sind, wobei die beiden Spannungskontakte vorzugsweise möglichst nah an dem Widerstandselement innerhalb der plattenförmigen Anschlussteile angeordnet sind.

Beispielsweise kann es sich bei den Spannungskontakten um eine Ausprägung handeln, wie es beispielsweise in DE 10 2009 031 408 beschrieben ist. Alternativ besteht jedoch auch die Möglichkeit, dass die Spannungskontakte als Kontaktierungsflächen ausgebildet sind, wie es beispielsweise in EP 0 605 800 A1 beschrieben ist. Darüber hinaus bestehen im Rahmen der Erfindung auch verschiedene andere Möglichkeiten zur konstruktiven Gestaltung der Spannungskontakte.

Bei einem solchen Aufbau des erfindungsgemäßen Strommesswiderstands mit zwei Spannungskontakten ist vorzugsweise in jedem der beiden zugehörigen plattenförmigen Anschlussteile jeweils mindestens ein Einschnitt vorgesehen, um die Temperaturabhängigkeit der Messung zu verringern.

Die beiden Einschnitte in den beiden plattenförmigen Anschlussteilen sind hierbei vorzugsweise so angeordnet, dass die Stromlinien und die Äquipotentiallinien in den plattenförmigen Anschlussteilen so verformt werden, dass die durch die Spannungskontakte verlaufenden Äquipotentiallinien in den plattenförmigen Anschlussteilen bis direkt an die Kontaktstelle (Fügestelle) mit dem Widerstandselement heran reichen, d.h. in der Regel bis an die Schweißnaht zwischen den plattenförmigen Anschlussteilen und dem Widerstandselement. Dies hat den Vorteil, dass die Spannungskontakte dann auf demselben elektrischen Potential liegen wie die Kanten des Widerstandselements, so dass die Spannungsmessung durch das Leitermaterial der plattenförmigen Anschlussteile überhaupt nicht verfälscht wird.

Die beiden Einschnitte in den beiden plattenförmigen Anschlussteilen sind deshalb vorzugsweise jeweils auf der dem Widerstandselement abgewandten Seite des jeweiligen Spannungskontakts angeordnet. Die beiden Einschnitte verlaufen also vorzugsweise zwischen den Spannungskontakten und den jeweiligen Stromkontakten, die zur Einleitung bzw. Ableitung des zu messenden elektrischen Stroms dienen und elektrisch und mechanisch mit den jeweiligen plattenförmigen Anschlussteilen verbunden sind.

Auch hinsichtlich der konstruktiven Gestaltung dieser Stromkontakte bestehen im Rahmen der Erfindung verschiedene Möglichkeiten, die beispielsweise in EP 0 605 800 A1 und in DE 10 2009 031 408 beschrieben sind. Weiterhin ist zu erwähnen, dass die Einschnitte vorzugsweise bogenförmig sind, wobei sich die Einschnitte über einen Bogenwinkel von mehr als 30°, 40°, 50°, 60° oder sogar 70° erstrecken können.

Ferner ist zu erwähnen, dass die Einschnitte in den plattenförmigen Anschlussteilen in dem bevorzugten Ausführungsbeispiel jeweils von den Stromkontakten weg und zu den Widerstandselementen hin gekrümmt oder angewinkelt sind.

Hierbei weist der Einschnitt vorzugsweise eine Breite auf, die über die Länge des Einschnitts im Wesentlichen konstant ist. Die Einschnitte sind also vorzugsweise schlitzförmig, obwohl auch andere Formen möglich sind.

Darüber hinaus ist zu erwähnen, dass sich der Einschnitt vorzugsweise von einem Rand des jeweiligen Anschlussteils ausgehend nach innen erstreckt, wobei die Einschnitte in den beiden Anschlussteilen vorzugsweise von dem selben Rand ausgehen.

Ferner ist zu bemerken, dass der Einschnitt vorzugsweise nicht bis zu dem Widerstandselement oder dem gegenüber liegenden Rand des jeweiligen plattenförmigen Anschlussteils reicht, so dass die Spannungskontakte das Widerstandselement trotz des Einschnitts auf seiner gesamten Breite über das plattenförmige Anschlussteil kontaktieren können.

Durch die erfindungsgemäße Anordnung von Einschnitten in den plattenförmigen Anschlussteilen ist es im Rahmen der Erfindung möglich, dass der Temperaturkoeffizient des Widerstands des gesamten Strommesswiderstands um mindestens 30%, 40%, 50% oder sogar 60% kleiner ist als bei einem ansonsten baugleichen Strommesswiderstand ohne einen solchen Einschnitt.

Bei dem bevorzugten Ausführungsbeispiel der Erfindung handelt es sich bei dem verwendeten Leitermaterial für die plattenförmigen Anschlussteile um Kupfer oder eine Kupferlegierung. Die Erfindung ist jedoch hinsichtlich des verwendeten Leitermaterials nicht auf die vorstehend genannten Beispiele beschränkt.

Ferner ist zu erwähnen, dass es sich bei dem Widerstandsmaterial für das Widerstandselement vorzugsweise um eine Kupferlegierung handelt, insbesondere eine Kupfer-Mangan-Nickel-Legierung, wie beispielsweise Cu84Ni4Mn12 (Manganin®). Die Erfindung ist jedoch hinsichtlich des verwendeten Widerstandsmaterials für das Widerstandselement nicht auf die vorstehend genannten Beispiele beschränkt. Allerdings weist das Widerstandsmaterial des Widerstandselements eine geringere Leitfähigkeit bzw. einen größeren spezifischen Widerstand auf als das Leitermaterial der plattenförmigen Anschlussteile.

Weiterhin ist zu erwähnen, dass das Widerstandselement vorzugsweise elektrisch und mechanisch mit den beiden Anschlussteilen verbunden ist, insbesondere eine Schweißverbindung, wobei sich eine Verbindung durch Elektronenstrahlschweißen besonders eignet, wie bereits in EP 0 605 800 A1 ausführlich beschrieben ist. Schließlich ist noch zu erwähnen, dass die beiden Anschlussteile vorzugsweise auf gegenüber liegenden Seiten des Widerstandselements angeordnet sind, so dass sich das Widerstandselement zwischen den beiden Anschlussteilen befindet. Es besteht jedoch alternativ auch die Möglichkeit, dass die beiden Anschlussteile auf der selben Seite des Widerstandselements angeordnet sind.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine Perspektivansicht eines erfindungsgemäßen Strommesswiderstands,
- Figur 2: eine Aufsicht auf den Strommesswiderstand aus Figur 1,
- Figur 3: eine Seitenansicht des Strommesswiderstands aus den Figuren 1 und 2,
- Figur 4: eine Detailansicht des Strommesswiderstands aus Figur 2,
- Figur 5A: eine Aufsicht auf einen herkömmlichen Strommesswiderstand mit der Verteilung der Stromlinien und der Äquipotentiallinien zwischen den Spannungskontakten,
- Figur 5B: zum Vergleich eine Aufsicht auf den erfindungsgemäßen Strommesswiderstand, sowie
- Figur 6: ein Diagramm zur Verdeutlichung der Temperaturabhängigkeit des Widerstandswerts des erfindungsgemäßen Strommesswiderstand im Vergleich zu einem herkömmlichen Strommesswiderstand.

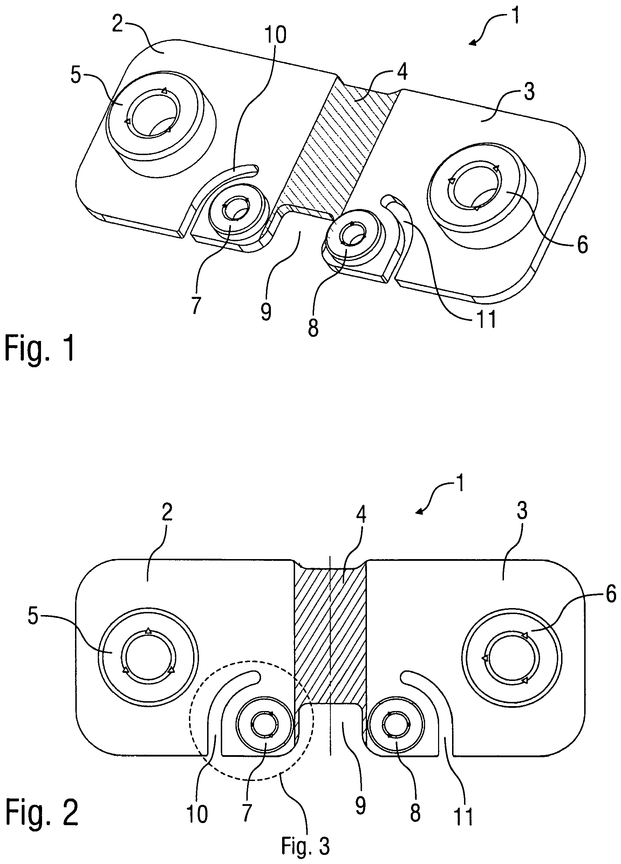

Die Figuren 1 bis 4 und 5B zeigen ein bevorzugtes Ausführungsbeispiel eines erfindungsgemäßen Strommesswiderstands 1, der beispielsweise zur Strommessung gemäß der bekannten Vierleitertechnik in einem Kraftfahrzeugbordnetz eingesetzt werden kann.

Der erfindungsgemäße Strommesswiderstand 1 entspricht weitgehend einem herkömmlichen Strommesswiderstand, wie er beispielsweise in EP 0 605 800 A1 beschrieben ist. Der erfindungsgemäße Strommesswiderstand 1 besteht im Wesentlichen aus zwei plattenförmigen Anschlussteilen 2, 3 aus einem Leitermaterial (z.B. Kupfer) und einem zwischen die beiden plattenförmigen Anschlussteile 2, 3 eingesetzten und ebenfalls plattenförmigen Widerstandselement 4 aus einem niederohmigen Widerstandsmaterial (z.B. Cu84Ni4Mn12). Die beiden plattenförmigen Anschlussteile 2, 3 sind hierbei auf gegenüber liegenden Seiten des ebenfalls plattenförmigen Widerstandselements 4 angeordnet und mit dem plattenförmigen Widerstandselement 4 verschweißt.

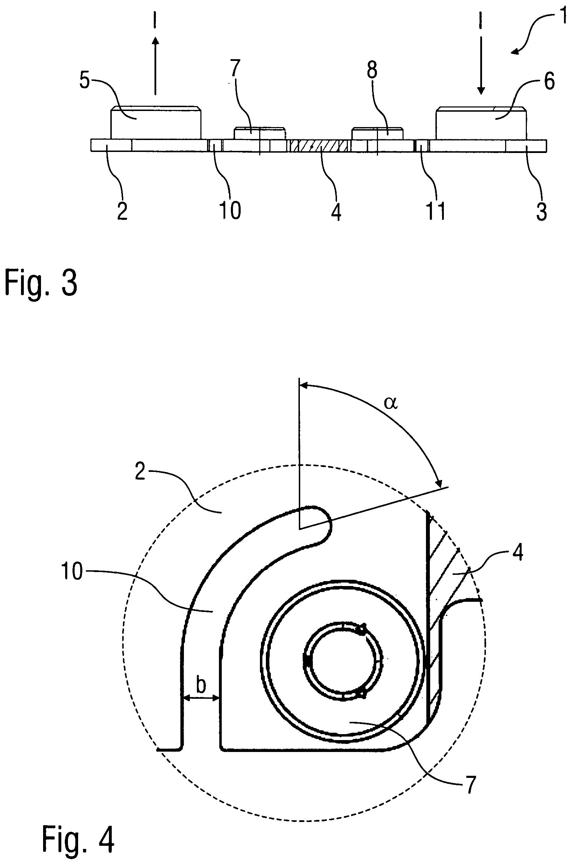

Darüber hinaus weist der erfindungsgemäße Strommesswiderstand 1 zwei Stromkontakte 5, 6 auf, die elektrisch und mechanisch mit den beiden plattenförmigen Anschlussteilen 2, 3 verbunden sind, wobei der Stromkontakt 6 zur Einleitung eines zu messenden elektrischen Stroms I dient, während der Stromkontakt 5 zur Ableitung des zu messenden elektrischen Stroms I dient, wie insbesondere aus der Seitenansicht in Figur 3 ersichtlich ist.

Weiterhin verfügt der erfindungsgemäße Strommesswiderstand 1 über zwei Spannungskontakte 7, 8, die elektrisch und mechanisch mit den beiden plattenförmigen Anschlussteilen 2, 3 verbunden sind und zur Messung der über dem Widerstandselement 4 abfallenden elektrischen Spannung dienen. Die beiden Spannungskontakte 7, 8 sind deshalb in den plattenförmigen Anschlussteilen 2, 3 sehr nahe an dem Widerstandselement 4 angeordnet, damit die Spannungsmessung nicht durch die über den Anschlussteilen 2, 3 abfallende elektrische Spannung verfälscht wird.

Ferner ist noch zu erwähnen, dass der erfindungsgemäße Strommesswiderstand 1 im Bereich des Widerstandselements 4 seitlich einen Einschnitt 9 aufweist, der zur Kalibrierung bzw. Justierung des gewünschten Widerstandswerts des Strommesswiderstands 1 eingesetzt werden kann, indem der Einschnitt 9 im Rahmen der Herstellung mehr oder weniger groß ausgebildet wird.

Wichtig ist jedoch für die erfindungsgemäße Funktion, dass in den beiden plattenförmigen Anschlussteilen 2, 3 jeweils ein Einschnitt 10, 11 angeordnet ist, um die Temperaturabhängigkeit der Messung zu verringern. Die beiden Einschnitte 10, 11 erstrecken sich hierbei jeweils von dem selben Rand des plattenförmigen Anschlussteils 2 bzw. 3 quer nach innen und sind dann bogenförmig um die jeweiligen Spannungskontakte 7 bzw. 8 herumgeführt, wobei sich die beiden Einschnitte 10, 11 über einen Bogenwinkel α≈70° erstrecken, wie insbesondere aus der Detailansicht in Figur 4 ersichtlich ist.

Weiterhin ist aus der Detailansicht in Figur 4 ersichtlich, dass die beiden Einschnitte 10, 11 schlitzförmig sind und eine Breite b aufweisen, die über die Länge der Einschnitte 10, 11 im Wesentlichen konstant ist.

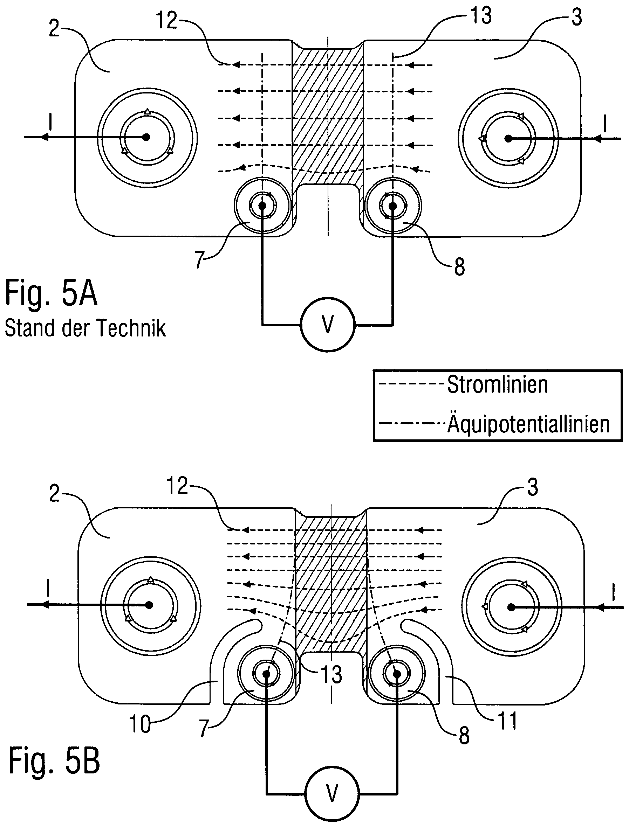

Die Funktion der beiden Einschnitte 10, 11 wird deutlich, wenn man die beiden Figuren 5A und 5B vergleicht, wobei Figur 5A den Verlauf von Stromlinien 12 und Äquipotentiallinien 13 bei einem herkömmlichen Strommesswiderstand 1 zeigt, wohingegen Figur 5B den Verlauf der Stromlinien 12 und der Äquipotentiallinien 13 bei dem erfindungsgemäßen Strommesswiderstand 1 zeigt. Die Stromlinien 12 definieren hierbei eine Hauptstromrichtung, wobei die Einschnitte 10, 11 teilweise quer zu dieser Hauptstromrichtung ausgerichtet sind, um den Stromverlauf zu beeinflussen.

Aus diesem Vergleich ist ersichtlich, dass bei dem herkömmlichen Strommesswiderstand 1 gemäß Figur 5A die durch die Spannungskontakte 7, 8 verlaufenden Äquipotentiallinien 13 nicht exakt auf demselben elektrischen Potential liegen wie die äußeren Kanten des Widerstandselements 4. Dies bedeutet, dass die zwischen den Spannungskontakten 7, 8 gemessene Spannung teilweise aus der Spannung besteht, die über den plattenförmigen Anschlussteilen 2, 3 abfällt. Damit wird die gemessene Spannung auch durch die relativ hohe Temperaturabhängigkeit des Leitermaterials der Anschlussteile 2, 3 beeinflusst.

Bei dem erfindungsgemäßen Strommesswiderstand 1 gemäß Figur 5B verformen die Einschnitte 10, 11 dagegen die Stromlinien 12 und die Äquipotentiallinien 13 so, dass die durch die Spannungskontakte 7, 8 verlaufenden Äquipotentiallinien bis an die äußeren Kanten des Widerstandselements 4 heran reichen und deshalb auf demselben elektrischen Potential liegen. Bei der Spannungsmessung wird also ausschließlich die Spannung gemessen, die über dem Widerstandselement 4 abfällt. Dies ist vorteilhaft, weil das Leitermaterial (z.B. Kupfer) der plattenförmigen Anschlussteile 2, 3 in der Regel eine wesentlich größere Temperaturabhängigkeit hinsichtlich des spezifischen elektrischen Widerstands aufweist als das Widerstandsmaterial (z.B. Manganin®) des Widerstandselements 4. Hierbei schmiegen sich die Äquipotentiallinien 13 asymptotisch an die Schweißkante zwischen den plattenförmigen Anschlussteilen 2, 3 und dem Widerstandselement 4 an.

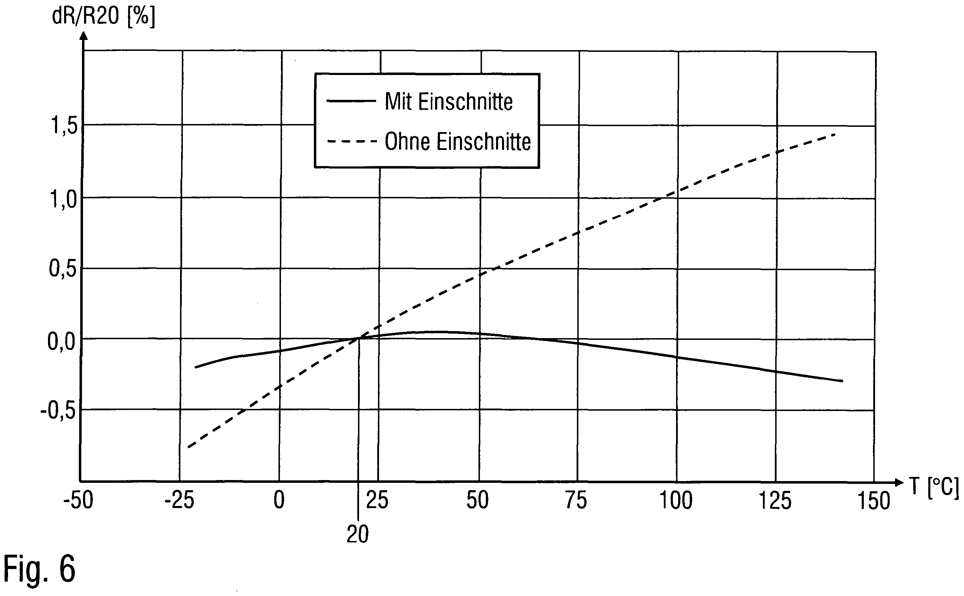

Die erfindungemäße Gestaltung des Strommesswiderstands 1 mit den Einschnitten 10, 11 führt zu einer deutlichen Verringerung der Temperaturabhängigkeit bei der Strommessung, wie aus dem Diagramm in Figur 6 ersichtlich ist, das die Temperaturabhängigkeit des Widerstandswerts R in Abhängigkeit von der Temperatur T zeigt.

Die Erfindung ist nicht auf das vorstehend beschriebene bevorzugte Ausführungsbeispiel beschränkt. Vielmehr ist der Schutzbereich durch die Merkmale des unabhängigen Anspruchs 1 definiert.

### Bezugszeichenliste:

- 1: Strommesswiderstand
- 2: Anschlussteil
- 3: Anschlussteil
- 4: Widerstandselement
- 5: Stromkontakt
- 6: Stromkontakt
- 7: Spannungskontakt
- 8: Spannungskontakt
- 9: Einschnitt
- 10: Einschnitt
- 11: Einschnitt
- 12: Stromlinien
- 13: Äquipotentiallinien

## Patentansprüche

1. Strommesswiderstand (1) zur Messung eines elektrischen Stroms (I), mit
a) einem plattenförmigen ersten Anschlussteil (3) zur Einleitung des zu messenden elektrischen Stroms (I), wobei das plattenförmige erste Anschlussteil (3) aus einem elektrisch leitfähigen Leitermaterial besteht,
b) einem plattenförmigen zweiten Anschlussteil (2) zur Ableitung des zu messenden elektrischen Stroms (I), wobei das plattenförmige zweite Anschlussteil (2) aus einem elektrisch leitfähigen Leitermaterial besteht,
c) einem plattenförmigen Widerstandselement (4), das im Strompfad zwischen die beiden Anschlussteile geschaltet ist und von dem zu messenden elektrischen Strom (I) durchflossen wird, wobei das Widerstandselement (4) aus einem niederohmigen Widerstandsmaterial besteht und das Widerstandsmaterial einen größeren spezifischen Widerstand aufweist als das Leitermaterial der Anschlussteile (2, 3),
d) jeweils einem Einschnitt (10, 11) in dem plattenförmigen ersten Anschlussteil (3) und in dem plattenförmigen zweiten Anschlussteil (2),
e) wobei der zu messende elektrische Strom (I) entlang einer Hauptstromrichtung (12) zwischen den beiden Anschlussteilen (2, 3) fließt,
**dadurch gekennzeichnet,**
f) **dass** die Einschnitte (10, 11) mindestens auf einem Teil ihrer Länge quer zu der Hauptstromrichtung (12) ausgerichtet sind, um die Temperaturabhängigkeit der Messung zu verringern.

2. Strommesswiderstand (1) nach Anspruch 1, **dadurch gekennzeichnet,**
a) **dass** ein erster Spannungskontakt (8) elektrisch und mechanisch mit dem plattenförmigen ersten Anschlussteil (3) verbunden ist,
b) **dass** ein zweiter Spannungskontakt (7) elektrisch und mechanisch mit dem plattenförmigen plattenförmigen zweiten Anschlussteil (2) verbunden ist.

3. Strommesswiderstand (1) nach Anspruch 2,
**dadurch gekennzeichnet,**
a) **dass** in dem ersten plattenförmigen Anschlussteil (3) eine erste Äquipotentiallinie (13) von dem ersten Spannungskontakt (7) bis zu einer Kontaktstelle mit dem Widerstandselement (4) verläuft, so dass der erste Spannungskontakt (7) auf demselben elektrischen Potential liegt wie die Kontaktstelle mit dem Widerstandselement (4), und
b) **dass** in dem zweiten plattenförmigen Anschlussteil (2) eine zweite Äquipotentiallinie von dem zweiten Spannungskontakt (8) bis zu einer Kontaktstelle mit dem Widerstandselement (4) verläuft, so dass der zweite Spannungskontakt (8) auf demselben elektrischen Potential liegt wie die Kontaktstelle mit dem Widerstandselement (4) .

4. Strommesswiderstand (1) nach Anspruch 2 oder 3,
**dadurch gekennzeichnet,**
a) **dass** der erste Einschnitt (11) in dem ersten Anschlussteil (3) auf der dem Widerstandselement (4) abgewandten Seite des ersten Spannungskontakts (8) angeordnet ist,
b) **dass** der zweite Einschnitt (10) in dem plattenförmigen zweiten Anschlussteil (2) auf der dem Widerstandselement (4) abgewandten Seite des zweiten Spannungskontakts (7) angeordnet ist.

5. Strommesswiderstand (1) nach einem der Ansprüche 2 bis 4, **dadurch gekennzeichnet,**
a) **dass** sich der erste Einschnitt (11) in dem plattenförmigen ersten Anschlussteil (3) bogenförmig oder winkelförmig um den ersten Spannungskontakt (8) erstreckt, und
b) **dass** sich der zweite Einschnitt (10) in dem plattenförmigen zweiten Anschlussteil (2) bogenförmig oder winkelförmig um den zweiten Spannungskontakt (7) erstreckt.

6. Strommesswiderstand (1) nach einem der vorhergehenden Ansprüche, **dadurch gekennzeichnet,**
a) **dass** der Einschnitt (10, 11) bogenförmig gekrümmt ist, und/oder
b) **dass** sich der Einschnitt (10, 11) über einen Bogenwinkel (α) von mehr als 30°, 40°, 50°, 60° oder 70° erstreckt.

7. Strommesswiderstand (1) nach einem der vorhergehenden Ansprüche, **dadurch gekennzeichnet,**
a) **dass** ein erster Stromkontakt (6) elektrisch und mechanisch mit dem plattenförmigen ersten Anschlussteil (3) verbunden ist, wobei der erste Stromkontakt (6) zum Einleiten des zu messenden elektrischen Stroms (I) dient, und
b) **dass** ein zweiter Stromkontakt (5) elektrisch und mechanisch mit dem plattenförmigen plattenförmigen zweiten Anschlussteil (2) verbunden ist, wobei der zweite Stromkontakt (5) zum Ableiten des zu messenden elektrischen Stroms (I) dient.

8. Strommesswiderstand (1) nach Anspruch 7, **dadurch gekennzeichnet, dass** die Einschnitte (10, 11) in den plattenförmigen Anschlussteilen (2, 3) jeweils von den Stromkontakten (5, 6) weg und zu dem Widerstandselement (4) hin gekrümmt oder angewinkelt sind.

9. Strommesswiderstand (1) nach einem der vorhergehenden Ansprüche, **dadurch gekennzeichnet,**
a) **dass** der Einschnitt (10, 11) über seine Länge eine im Wesentlichen konstante Breite (b) aufweist, und/oder
b) **dass** der Einschnitt (10, 11) von einem Rand des ersten Anschlussteils und/oder des plattenförmigen zweiten Anschlussteils (2) ausgeht und sich nach innen erstreckt, und/oder
c) **dass** der mindestens eine Einschnitt (10, 11) jeweils nicht bis zu dem Widerstandselement (4) reicht, so dass die Spannungskontakte (7, 8) das Widerstandselement (4) auf seiner gesamten Breite über das plattenförmige Anschlussteil (2, 3) kontaktieren können.

10. Strommesswiderstand (1) nach einem der vorhergehenden Ansprüche, **dadurch gekennzeichnet,**
a) **dass** der Strommesswiderstand (1) einen bestimmten Widerstandswert mit einem bestimmten Temperaturkoeffizienten aufweist, und
b) **dass** der Temperaturkoeffizient des Widerstandswerts um mindestens 30%, 40%, 50% oder 60% kleiner ist als bei einem ansonsten baugleichen Strommesswiderstand (1) ohne einen Einschnitt (10, 11) in den plattenförmigen Anschlussteilen (2, 3).

11. Strommesswiderstand (1) nach einem der vorhergehenden Ansprüche, **dadurch gekennzeichnet,**
a) **dass** das Leitermaterial Kupfer oder eine Kupferlegierung ist, und/oder
b) **dass** das Widerstandsmaterial eine Kupferlegierung ist, insbesondere eine Kupfer-Mangan-Nickel-Legierung, insbesondere Cu84Ni4Mn12, und/oder
c) **dass** das Widerstandselement (4) elektrisch und mechanisch mit den beiden Anschlussteilen (2, 3) verbunden ist, insbesondere durch eine Schweißverbindung, und/oder
d) **dass** die beiden Anschlussteile (2, 3) auf gegenüberliegenden Seiten des Widerstandselements (4) angeordnet sind, und/oder
e) **dass** die plattenförmigen Anschlussteile (2, 3) und/oder das plattenförmige Widerstandselement (4) eben oder gebogen sind.

## Claims

1. A current-sense resistor (1) for measuring an electric current (I), with
a) a plate-shaped first connecting part (3) for introducing the electric current (I) to be measured, wherein the plate-shaped first connecting part (3) consists of an electrically conductive conductor material,
b) a plate-shaped second connecting part (2) for conducting away the electric current (I) to be measured, wherein the plate-shaped second connecting part (2) consists of an electrically conductive conductor material,
c) a plate-shaped resistance element (4), which is connected in the current path between both connecting parts and through which the electric current (I) to be measured flows, wherein the resistance element (4) consists of a low-ohm resistance material and the resistance material comprises a greater specific resistance value than the conductor material of the connecting parts (2, 3),
d) an incision (10, 11) in each of the plate-shaped first connecting part (3) and the plate-shaped second connecting part (2),
e) wherein the electric current (I) to be measured flows along a main current direction (12) between both connecting parts (2, 3),
**characterized in that**
f) the incisions (10, 11) are orientated at least on a portion of their length transversely with respect to the main current direction (12) in order to reduce the temperature dependency of the measurement.

2. The current-sense resistor (1) according to claim 1, **characterized in that**
a) a first voltage contact (8) is connected electrically and mechanically with the plate-shaped first connecting part (3),
b) a second voltage contact (7) is connected electrically and mechanically with the plate-shaped second connecting part (2),

3. The current-sense resistor (1) according to Claim 2, **characterized in that**
a) in the first plate-shaped connecting part (3), a first equipotential line (13) runs from the first voltage contact (7) to a contact point with the resistance element (4), so that the first voltage contact (7) lies on the same electric potential as the contact point with the resistance element (4), and
b) in the second plate-shaped connecting part (2), a second equipotential line (13) runs from the second voltage contact (8) to a contact point with the resistance element (4), so that the second voltage contact (8) lies on the same electric potential as the contact point with the resistance element (4).

4. The current-sense resistor (1) according to Claim 2 or 3, **characterized in that**
a) the first incision (11) in the first connecting part (3) is arranged on the side of the first voltage contact (8) facing away from the resistance element (4),
b) the second incision (10) in the plate-shaped second connecting part (2) is arranged on the side of the second voltage contact (7) facing away from the resistance element (4).

5. The current-sense resistor (1) according to any of claims 2 to 4, **characterized in that**
a) the first incision (11) in the plate-shaped first connecting part (3) extends in an arched or in an angular manner around the first voltage contact (8), and
b) the second incision (10) in the plate-shaped second connecting part (2) extends in an arched or in an angular manner around the second voltage contact (7).

6. The current-sense resistor (1) according to any one of the preceding claims, **characterized in that**
a) the incision (10, 11) is arc-bent, and/or
b) the incision (10, 11) extends over an arc angle (α) of more than 30°, 40°, 50°, 60° or 70°.

7. The current-sense resistor (1) according to any one of the preceding claims, **characterized in that**
a) a first current contact (6) is connected electrically and mechanically with the plate-shaped first connection part (3), wherein the first current contact (6) serves for introducing the electric current (I) to be measured, and
b) a second current contact (5) is connected electrically and mechanically with the plate-shaped second connection part (2), wherein the second current contact (5) serves for conducting away the electric current (I) to be measured.

8. The current-sense resistor (1) according to Claim 7, **characterized in that** the incision (10, 11) in the plate-shaped connecting parts (2, 3) is respectively bent away or angled from the current contacts (5, 6) and towards the resistance element (4).

9. The current-sense resistor (1) according to any one of the preceding claims, **characterized in that**
a) the incision (10, 11) has a substantially constant width (b) over its length, and/or
b) the incision (10, 11) originates from an edge of the first connecting part and/or of the plate-shaped second connecting part (2) and extends inwards, and/or
c) the at least one incision (10, 11) does not respectively reach until the resistance element (4), so that the voltage contacts (7, 8) can contact the resistance element (4) on its entire width via the plate-shaped connecting part (2, 3).

10. The current-sense resistor (1) according to any one of the preceding claims, **characterized in that**
a) the current-sense resistor (1) has a defined resistance value with a defined temperature coefficient, and
b) the temperature coefficient of the resistance value is by at least 30%, 40%, 50% or 60% smaller than for a current-sense resistor (1) with an otherwise identical construction without an incision (10, 11) in the plate-shaped connecting parts (2, 3).

11. The current-sense resistor (1) according to any one of the preceding claims, **characterized in that**
a) the conductor material is copper or a copper alloy, and/or
b) the resistance material is a copper alloy, in particular a copper-manganese-nickel alloy, in particular Cu84Ni4Mn12, and/or
c) the resistance element (4) is connected electrically and mechanically with both connecting parts (2, 3), in particular through a welded joint, and/or
d) both connecting parts (2, 3) are arranged on opposite sides of the resistance element (4), and/or
e) the plate-shaped connecting parts (2, 3) and/or the plate-shaped resistance element (4) are even or bent.

## Revendications

1. Résistance de mesure de courant (1) pour mesurer un courant électrique (I), avec
a) une première pièce de connexion en forme de plaque (3) pour l'introduction du courant électrique (I) à mesurer, dans laquelle la première pièce de connexion en forme de plaque (3) est constituée d'un matériau conducteur électriquement conducteur,
b) une seconde pièce de connexion en forme de plaque (2) pour la dérivation du courant électrique (I) à mesurer, dans laquelle la seconde pièce de connexion en forme de plaque (2) est constituée d'un matériau conducteur électriquement conducteur,
c) un élément de résistance (4) en forme de plaque qui est monté sur le trajet de courant entre les deux pièces de connexion et est traversé par le courant électrique (I) à mesurer, dans laquelle l'élément de résistance (4) est constitué d'un matériau de résistance de faible valeur ohmique et le matériau de résistance présente une résistance spécifique supérieure à celle du matériau conducteur des pièces de connexion (2, 3),
d) respectivement une encoche (10, 11) dans la première pièce de connexion en forme de plaque (3) et dans la seconde pièce de connexion en forme de plaque (2),
e) dans laquelle le courant électrique (I) à mesurer circule le long d'un sens de courant principal (12) entre les deux pièces de connexion (2, 3),
**caractérisée en ce**
f) **que** les encoches (10, 11) sont orientées au moins sur une partie de leur longueur transversalement au sens de courant principal (12), afin de réduire la dépendance de la mesure vis-à-vis de la température.

2. Résistance de mesure de courant (1) selon la revendication 1, **caractérisée en ce**
a) **qu'**un premier contact de tension (8) est relié électriquement et mécaniquement à la première pièce de connexion en forme de plaque (3),
b) **qu'**un second contact de tension (7) est relié électriquement et mécaniquement à la seconde pièce de connexion en forme de plaque (2).

3. Résistance de mesure de courant (1) selon la revendication 2, **caractérisée en ce**
a) **que**, dans la première pièce de connexion en forme de plaque (3), une première ligne équipotentielle (13) va du premier contact de tension (7) jusqu'à un point de contact avec l'élément de résistance (4), de telle sorte que le premier contact de tension (7) est au même potentiel électrique que le point de contact avec l'élément de résistance (4), et
b) **que**, dans la seconde pièce de connexion en forme de plaque (2), une seconde ligne équipotentielle va du second contact de tension (8) jusqu'à un point de contact avec l'élément de résistance (4), de telle sorte que le second contact de tension (8) est au même potentiel électrique que le point de contact avec l'élément de résistance (4).

4. Résistance de mesure de courant (1) selon la revendication 2 ou 3, **caractérisée en ce**
a) **que** la première encoche (11) dans la première pièce de connexion (3) est disposée sur le côté du premier contact de tension (8) détourné de l'élément de résistance (4),
b) **que** la seconde encoche (10) dans la seconde pièce de connexion en forme de plaque (2) est disposée sur le côté du second contact de tension (7) détourné de l'élément de résistance (4).

5. Résistance de mesure de courant (1) selon l'une des revendications 2 à 4, **caractérisée en ce**
a) **que** la première encoche (11) dans la première pièce de connexion en forme de plaque (3) s'étend de manière arquée ou angulaire autour du premier contact de tension (8), et
b) **que** la seconde encoche (10) dans la seconde pièce de connexion en forme de plaque (2) s'étend de manière arquée ou angulaire autour du second contact de tension (7).

6. Résistance de mesure de courant (1) selon l'une des revendications précédentes, **caractérisée en ce**
a) **que** l'encoche (10, 11) est courbée de manière arquée, et/ou
b) **que** l'encoche (10, 11) s'étend sur un coude en arc (α) de plus de 30°, 40°, 50°, 60° ou 70°.

7. Résistance de mesure de courant (1) selon l'une des revendications précédentes, **caractérisée en ce**
a) **qu'**un premier contact électrique (6) est relié électriquement et mécaniquement à la première pièce de connexion en forme de plaque (3), dans laquelle le premier contact électrique (6) sert à introduire le courant électrique (I) à mesurer, et
b) **qu'**un second contact électrique (5) est relié électriquement et mécaniquement à la seconde pièce de connexion en forme de plaque (2), dans laquelle le second contact électrique (5) sert à dériver le courant électrique (I) à mesurer.

8. Résistance de mesure de courant (1) selon la revendication 7, **caractérisée en ce que** les encoches (10, 11) dans les pièces de connexion en forme de plaque (2, 3) sont courbées ou pliées respectivement en s'éloignant des contacts électriques (5, 6) et en se rapprochant de l'élément de résistance (4).

9. Résistance de mesure de courant (1) selon l'une des revendications précédentes, **caractérisée en ce**
a) **que** l'encoche (10, 11) présente sur sa longueur une largeur (b) sensiblement constante, et/ou
b) **que** l'encoche (10, 11) part d'un bord de la première pièce de connexion et/ou de la seconde pièce de connexion en forme de plaque (2) et s'étend vers l'intérieur, et/ou
c) **que** l'au moins une encoche (10, 11) n'atteint respectivement pas l'élément de résistance (4), de telle sorte que les contacts de tension (7, 8) peuvent être en contact avec l'élément de résistance (4) sur toute sa largeur via la pièce de connexion en forme de plaque (2, 3).

10. Résistance de mesure de courant (1) selon l'une des revendications précédentes, **caractérisée en ce**
a) **que** la résistance de mesure de courant (1) présente une valeur de résistance déterminée avec un coefficient de température déterminé, et
b) **que** le coefficient de température de la valeur de résistance est inférieur d'au moins 30 %, 40 %, 50 % ou 60 % à celui d'une résistance de mesure de courant (1) de construction sinon identique, sans encoche (10, 11) dans les pièces de connexion en forme de plaque (2, 3) .

11. Résistance de mesure de courant (1) selon l'une des revendications précédentes, **caractérisée en ce**
a) **que** le matériau conducteur est du cuivre ou un alliage de cuivre, et/ou
b) **que** le matériau de résistance est un alliage de cuivre, en particulier un alliage cuivre-manganèsenickel, en particulier du Cu84Ni4Mn12, et/ou
c) **que** l'élément de résistance (4) est relié électriquement et mécaniquement aux deux pièces de connexion (2, 3), en particulier par une liaison soudée, et/ou
d) **que** les deux pièces de connexion (2, 3) sont disposées sur des côtés opposés de l'élément de résistance (4), et/ou
e) **que** les pièces de connexion en forme de plaque (2, 3) et/ou l'élément de résistance (4) en forme de plaque sont plats ou courbes.
